# EUROPEAN PATENT APPLICATION

(11) **EP 4 366 282 A1**
(43) Date of publication of application: **08.05.2024**
(21) Application number: 22893185.3
(22) Date of filing: 09.11.2022
(51) Int. Cl.: H04M 1/02, G06K 7/00, H04B 1/3818

(54) **ELECTRONIC DEVICE COMPRISING DETACHABLE STORAGE MEDIUM**

(30) Priority: 09.11.2021 KR 20210153344
(71) Applicant: Samsung Electronics Co., Ltd., Suwon-si, Gyeonggi-do 16677 (KR)
(72) Inventor: KIM, Jaeshik, Suwon-si Gyeonggi-do 16677 (KR)
(74) Representative: HGF
(86) International application number: PCT/KR2022/017542
(87) International publication number: WO 2023/085765

(57) **Abstract**

An electronic device is provided. The electronic device comprises: a housing forming at least part of the exterior of the device; a socket disposed inside the housing; a tray having on one side thereof a seating portion on which a storage medium can be seated, and detachably attached to the socket; and a storage medium including a first terminal surface having a terminal and a second terminal surface having a terminal, wherein the first and second terminal surfaces face opposite directions to each other and can be seated on the tray. The socket includes: a plurality of first conductive contacts facing the first terminal surface and contacting at least some of a plurality of pins formed on the storage medium; and a plurality of second conductive contacts facing the second terminal surface and contacting at least some of the plurality of pins of the storage medium in a state of being arranged so as not to contact the plurality of first conductive contacts.

## Description

### [Technical Field]

Various embodiments of the disclosure relate to an electronic device, for example, an electronic device in which a storage medium is detachably provided.

### [Background Art]

Typically, an electronic device means a device that performs a specific function according to a program incorporated therein, such as an electronic scheduler, a portable multimedia player, a mobile communication terminal, a tablet personal computer (PC), an image/sound device, a desktop/laptop PC, or a vehicle navigation system, as well as a home appliance. The above-mentioned electronic devices may output, for example, information stored therein as sound or an image. As the integration degree of electronic devices has increased and super-high speed and large-capacity wireless communication has become popular, various functions have recently been provided in a single mobile communication terminal. For example, various functions, such as an entertainment function (e.g., a game function), a multimedia function (e.g., a music/video playback function), a communication and security function for mobile banking, a schedule management function, or an e-wallet function, are integrated in a single electronic device, in addition to a communication function.

Among components or additional devices of an electronic device, a memory card (e.g., an SD card) may be useful for storing various document files or multimedia files. A memory card may be useful for expanding a storage capacity in storing, for example, various pieces of information received through the electronic device, generated by a user, or acquired through the electronic device.

An electronic device that is personally used by a user, such as a mobile communication terminal, may be provided with a subscriber identification module (SIM) for the purpose of user authentication or security. The subscriber identification module may take a form of a card that is similar to a memory card. For example, the subscriber identification module may be configured with a SIM card. When a storage medium, such as a memory card or a SIM card, is detachably provided, the storage medium may be useful for the expandability of a miniaturized electronic device, such as a mobile communication terminal.

### [Detailed Description of the Invention]

### [Technical Problem]

In making the exterior of a miniaturized electronic device beautiful, a single housing and/or a case structure (e.g., a unibody structure) using a metal material may be utilized. Even in the unibody structure, the housing may be provided with a jack or the like to connect an external device or to connect a connector for wired charging or an earphone. In an electronic device having a unibody structure, a tray structure may be used in detachably providing a storage medium in order to secure an expandability. For example, a tray on which a storage medium (e.g., a memory card or a SIM card) is seated may be inserted from the outside of the housing so as to mount the storage medium to the electronic device.

In a structure for detachably mounting a storage medium using a tray, for example, two different types of storage media (a subscriber identification module and a memory card) may be seated on a single tray. When two types of storage media are seated on a tray, it is necessary to provide two seating surfaces on the tray, and there may be a problem in that the thickness of the entire tray is increased with the two types of storage media. According to various embodiments of the disclosure, it is possible to provide an electronic device in which, in a structure for detachably mounting a storage medium by using a tray, the tray has a reduced thickness by integrating two types of storage media into one card.

### [Technical Solution]

According to various embodiments of the disclosure, it is possible to provide an electronic device including: a housing constituting at least a portion of an exterior of the electronic device; a socket disposed inside the housing; a tray detachably provided in the socket; and a storage medium including a first terminal surface with a terminal and a second terminal surface with a terminal, the first and second terminal surfaces facing away from one another and the storage medium being seatable on the try, and wherein the socket includes a plurality of first conductive contacts that face the first terminal surface and come into contact with at least some of a plurality of pins provided on the storage medium, and a plurality of second conductive contacts that face the second terminal surface and come into contact with at least some of the plurality of pins of the storage medium in a state of being disposed not to come into contact with the plurality of first conductive contacts.

According to various embodiments of the disclosure, it is possible to provide an electronic device including: a housing constituting at least a portion of an exterior of the electronic device; a socket disposed inside the housing; and a tray including on one surface thereof a seating portion and detachably provided in the socket, and a storage medium including a first terminal surface with a terminal and a second terminal surface with a terminal, the first and second terminal surfaces facing away from one another and the storage medium being seatable on the seating portion of the tray, and wherein the socket includes a plurality of first conductive contacts that face the first terminal surface and come into contact with at least some of a plurality of pins provided on the storage medium, a plurality of second conductive contacts that face the second terminal surface and come into contact with at least some of the plurality of pins of the storage medium in a state of being disposed not to come into contact with the plurality of first conductive contacts, and a plurality of third conductive contacts that do not come into contact with the plurality of pins of the storage medium.

According to various embodiments of the disclosure, it is possible to provide an electronic device including: a housing constituting at least a portion of an exterior of the electronic device; a socket disposed inside the housing; and a tray including on one surface thereof a seating portion on which the storage medium is seatable and detachably provided in the socket, wherein the socket includes a plurality of first conductive contacts that, when the storage medium is seated, face a first terminal surface of the storage medium and come into contact with at least some of a plurality of pins provided on the storage medium, a plurality of second conductive contacts that face a second terminal surface of the storage medium and come into contact with at least some of the plurality of pins of the storage medium in a state of being disposed not to come into contact with the plurality of first conductive contacts, and a plurality of third conductive contacts that do not come into contact with the plurality of pins of the storage medium.

### [Advantageous Effects]

In an electronic device according to various embodiments of the disclosure, in a structure for detachably mounting a storage medium by using a tray, it is possible to reduce the thickness of the tray by integrating two types of storage media into one card, and correspondingly, it is also possible to reduce the thickness of a socket that is capable of coming into contact with both surfaces of the card.

In addition, in an electronic device according to various embodiments of the disclosure, a socket including a plurality of conductive contacts that is capable of coming into contact with both surfaces of the card is provided and the plurality of conductive contacts are provided to overlap each other in the height direction of the socket, it is possible to increase a pressure. In this case, since the plurality of conductive contacts are provided not to interfere with each other, it is possible to prevent the storage media or the socket from being damaged.

### [Brief Description of Drawings]

FIG. 1 is a block diagram illustrating an electronic device according to various embodiments.
FIG. 2 is a perspective view illustrating a front surface of an electronic device according to various embodiments.
FIG. 3 is a perspective view illustrating a rear surface of an electronic device according to various embodiments.
FIG. 4 is a perspective view illustrating a socket and a tray according to a comparative embodiment.
FIG. 5 is a perspective view illustrating the tray according to the comparative embodiment.
FIG. 6 is a cross-sectional view illustrating a state in which the tray is mounted in the inner space of the socket according to the comparative embodiment.
FIG. 7 is a perspective view illustrating a socket and a tray according to another comparative embodiment.
FIG. 8 is a view illustrating a socket and a tray according to various embodiments.
FIG. 9 is a cross-sectional view illustrating a state in which the tray is mounted in the inner space of the socket according to various embodiments.FIG. 10 is a view illustrating the tray according to various embodiments when viewed from above.
FIG. 11 is a view illustrating a storage medium according to various embodiments.
FIG. 12 is a view illustrating a behavior of conductive contacts when a tray enters a socket according to various embodiments of the disclosure.
FIG. 13 is a view illustrating the socket according to various embodiments.
FIG. 14 is a view illustrating a cross section of a socket according to various embodiments, cut in a width direction.
FIG. 15 is a view illustrating a cross section of a socket according to various embodiments, cut in a longitudinal direction.
FIG. 16 is a view illustrating an arrangement relationship between first conductive contacts and second conductive contacts in a cross section of a socket according to various embodiments, cut in a longitudinal direction.
FIG. 17 is a view illustrating an arrangement relationship between first conductive contacts and second conductive contacts in a cross section of a socket according to various embodiments, cut in a longitudinal direction.
FIG. 18 is a view illustrating an arrangement relationship between first conductive contacts and second conductive contacts in a cross section of a socket according a comparative embodiment, cut in a longitudinal direction.
FIG. 19 is a view illustrating a storage medium according to various embodiments.
FIG. 20 is a view illustrating a tray according to various embodiments.

### [Mode for Carrying out the Invention]

The embodiments described below are provided so that a person ordinarily skilled in the art can easily understand the technical spirit of the disclosure, and the disclosure is not limited thereto. In addition, matters expressed in the accompanying drawings, which are drawings schematized for easily illustrating the embodiments of the disclosure, may be different from those actually implemented in shapes.

Before describing various embodiments of the disclosure in detail, it will be understood that the application of the embodiments is not limited to the details of the constructions and arrangements of components described in the following detailed description or illustrated in the drawings.

When a constituent element is referred to as being "connected" or "joined" to another constituent element, it should be understood that the constituent element may be directly connected or joined to the other element, but a still another constituent element may be present therebetween.

And, "connection" herein includes a direct connection and an indirect connection between one member and another member, and may refer to all physical connections and electrical connections such as adhesion, attachment, fastening, bonding, coupling, and the like.

Terms used herein are merely used for the purpose of describing specific embodiments and are not intended to limit the disclosure. An expression in a singular form includes an expression in a plural form as well, unless the context clearly indicates otherwise. It should be understood that terms, such as "comprise" and "have", used herein are intended to specify the presence of stated features, numbers, steps, operations, elements, components, or combinations thereof, but are not intended to preclude in advance the presence or addition of one or more other features, numbers, steps, operations, elements, components, or combinations thereof.

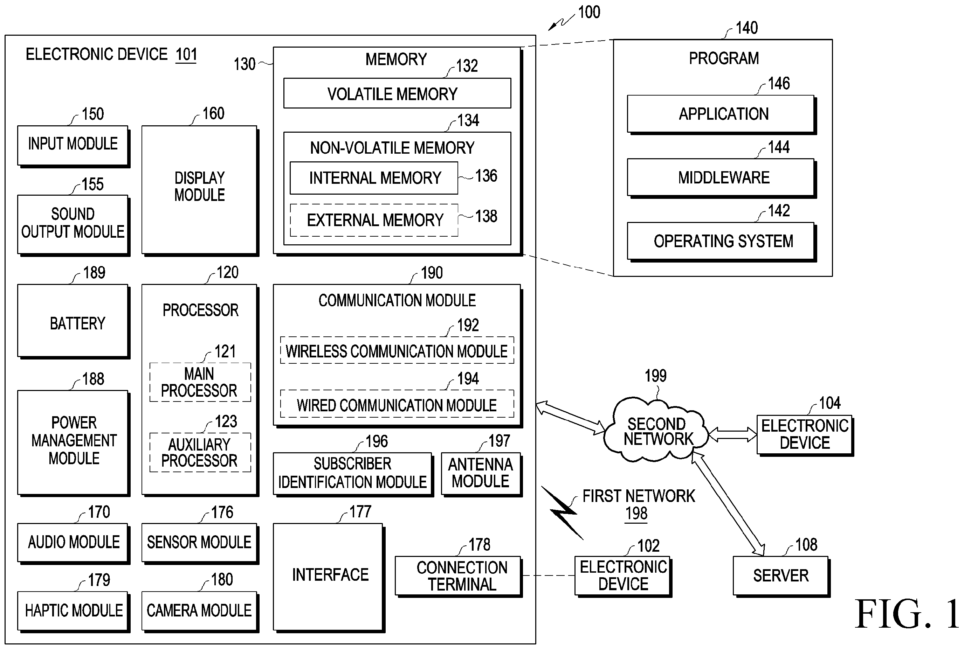

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connection terminal 178, a haptic module 179, a camera module 180, a power protection circuit 188, a battery 189, a communication module 190, a subscriber identification module (SIM) 196, or an antenna module 197. In some embodiments, at least one of the components (e.g., the connection terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connection terminal 178 may include a connector via which the electronic device 101 may be physically connected with the external electronic device (e.g., the electronic device 102). According to an embodiment, the connection terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power protection circuit 188 may manage power supplied to the electronic device 101. According to one embodiment, the power protection circuit 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

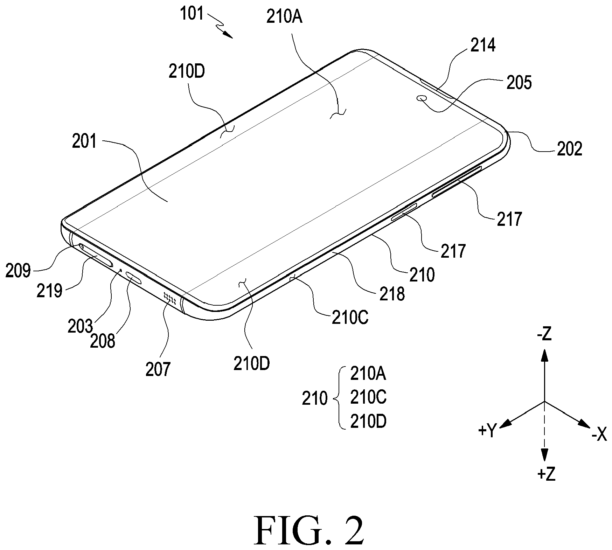

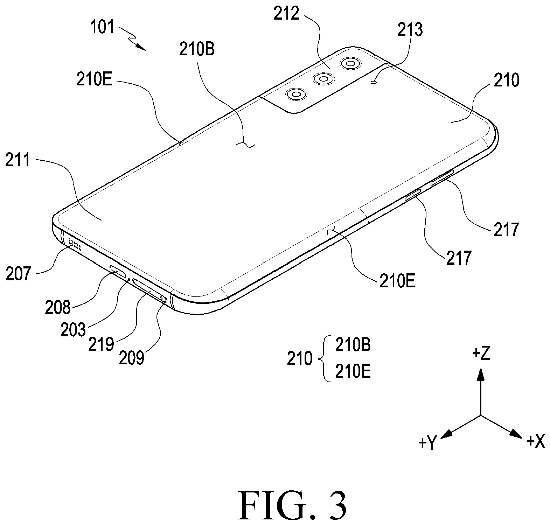

FIG. 2 is a perspective view illustrating the front surface of an electronic device 101 according to various embodiments of the disclosure. FIG. 3 is a perspective view illustrating the rear surface of the electronic device 101 according to various embodiments of the disclosure.

Referring to FIGS. 2 and 3, the electronic device 101 according to an embodiment may include a housing 210 including a front surface 210A, a rear surface 210B, and a side surface 210C surrounding a space between the front surface 210A and the rear surface 210B. In another embodiment (not illustrated), the housing 210 may refer to a structure defining a part of the front surface 210A in FIG. 2, the rear surface 210B, and the side surface 210C in FIG. 3. According an embodiment, at least a portion of the front surface 210A may be formed by a substantially transparent front plate 202 (e.g., a glass plate or a polymer plate including various coating layers). The rear surface 210B may be formed by a rear plate 211. The rear plate 211 may be formed of, for example, glass, ceramic, polymer, metal (e.g., aluminum, stainless steel (STS), or magnesium), or a combination of two or more of these materials. The side surface 210C may be formed by a side bezel structure (or a "side member") 218 coupled to the front plate 202 and the rear plate 211 and including metal and/or polymer. In some embodiments, the rear plate 211 and the side bezel structure 218 may be integrally configured with each other, and may include the same material (e.g., glass, a metal material such as aluminum, or ceramic).

In the illustrated embodiment, the front plate 202 may include, at the opposite ends of long edges thereof, two first edge areas 210D, which are bent from the front surface 210A toward the rear plate 211 and extend seamlessly. In the illustrated embodiment (see FIG. 3), the rear plate 211 may include, at the opposite ends of long edges thereof, two second edge areas 210E, which are bent from the rear surface 210B toward the front plate 202 and extend seamlessly. In some embodiments, the front plate 202 (or the rear plate 211) may include only one of the first edge areas 210D (or the second edge areas 210E). In another embodiment, some of the first edge areas 210D or the second edge areas 210E may not be included. In the embodiments described above, when viewed from a side of the electronic device 101, the side bezel structure 218 may have a first thickness (or width) on the side surface portions that do not include the first edge areas 210D or the second edge areas 210E described above, and may have a second thickness, which is smaller than the first thickness, on the side surface portions that include the first edge areas 210D or the second edge areas 210E.

According to an embodiment, the electronic device 101 may include at least one of a display device 201, audio modules 203, 207, and 214 (e.g., the audio module 170 in FIG. 1), a sensor module (e.g., the sensor module 176 in FIG. 1), camera modules 205, 212, and 213 (e.g., the camera module 180 in FIG. 1), key input devices 217 (e.g., the input module 150 in FIG. 1), a connector hole 208 (e.g., the connection terminal 178 in FIG. 1), and the tray hole 209. In some embodiments, in the electronic device 101, at least one of the above-mentioned components may be omitted or other components may be additionally included.

According to an embodiment, the display 201 may be visually exposed through a substantial portion of, for example, the front plate 202. In some embodiments, at least a portion of the display 201 may be visually exposed through the front plate 202 that defines the front surface 210A and the first edge areas 210D. In some embodiments, the edges of the display 201 may be configured to be substantially the same as the shape of the periphery of the front plate 202 adjacent thereto. In another embodiment (not illustrated), the distance between the periphery of the display 201 and the periphery of the front plate 202 may be substantially constant in order to increase the exposed area of the display 201.

According to an embodiment, the surface (or the front plate 202) of the housing 210 may include a screen display area provided since the display 201 is visually exposed. For example, the screen display area may include the front surface 210A and the first edge areas 210D.

In another embodiment (not illustrated), a portion of the screen display area (e.g., the front surface 210A and the first edge areas 210D) of the display 201 may be provided with a recess or an opening and may include at least one of an audio module 214, a sensor module (not illustrated), a light-emitting element (not illustrated), and a camera module 205, which are aligned with the recess or the opening. In another embodiment (not illustrated), the rear surface of the screen display area of the display 201 may include at least one of an audio module 214, a sensor module (not illustrated), a camera module 205, a fingerprint sensor (not illustrated), and a light-emitting element (not illustrated).

In another embodiment (not illustrated), the display 201 may be coupled to or disposed adjacent to a touch-sensitive circuit, a pressure sensor capable of measuring a touch intensity (pressure), and/or a digitizer configured to detect a magnetic field-type stylus pen.

In some embodiments, at least some of the key input devices 217 may be disposed in the first edge areas 210D and/or the second edge areas 210E.

According to an embodiment, the audio modules 203, 207, and 214 may include a microphone hole 203 and speaker holes 207 and 214. The microphone hole 203 may include a microphone disposed therein to acquire external sound, and in some embodiments, a plurality of microphones may be disposed therein to be able to detect the direction of sound. The speaker holes 207 and 214 may include an external speaker hole 207 and a call receiver hole 214. In some embodiments, the speaker holes 207 and 214 and the microphone hole 203 may be implemented as a single hole, or a speaker may be included without the speaker holes 207 and 214 (e.g., a piezo speaker). The audio modules 203, 207, and 214 are not limited to the above-described structure, and various design changes may be made, such as mounting only some audio modules or adding a new audio module, depending on the structure of the electronic device 101.

According to an embodiment, sensor modules (not illustrated) may generate an electrical signal or a data value corresponding to, for example, an internal operating state of the electronic device 101 or an external environmental state. The sensor modules (not illustrated) may include, for example, a first sensor module (not illustrated) (e.g., a proximity sensor) and/or a second sensor module (not illustrated) (e.g., a fingerprint sensor) disposed on the front surface 210A of the housing 210, and/or a third sensor module (not illustrated) (e.g., an HRM sensor) and/or a fourth sensor module (not illustrated) (e.g., a fingerprint sensor) disposed on the rear surface 210B of the housing 210. In some embodiments (not illustrated), the fingerprint sensor may be disposed not only on the front surface 210A (e.g., the display 201) of the housing 210, but also on the rear surface 210B. The electronic device 101 may further include at least one of sensor modules (not illustrated in the drawings), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor (not illustrated). The sensor modules (not illustrated) are not limited to the above-described structure, and various design changes such as mounting only some of the sensor modules and adding new sensor modules may be made depending on the structure of the electronic device 101.

According to an embodiment, the camera modules 205, 212, and 213 may include, for example, a front camera module 205 disposed on the front surface 210A of the electronic device 101, a rear camera module 212 disposed on the rear surface 210B, and/or a flash 213. The camera modules 205 and 212 may include one or more lenses, an image sensor, and/or an image signal processor. The flash 213 may include, for example, a light-emitting diode or a xenon lamp. In some embodiments, two or more lenses (e.g., an infrared camera, a wide-angle lens, and a telephoto lens), and image sensors may be disposed on one surface of the electronic device 101. The camera modules 205, 212, and 213 are not limited to the above-described structure, and various design changes such as mounting only some of the camera modules and adding new camera modules may be made depending on the structure of the electronic device 101.

According to an embodiment, the electronic device 101 may include a plurality of camera modules (e.g., a dual camera or a triple camera) having different properties (e.g., angles of view) or functions, respectively. For example, a plurality of camera modules 205 and 212 including lenses having different angles of view may be configured, and the electronic device 101 may control the change of the angles of view of the camera modules 205 and 212 executed therein based on a user's selection. For example, at least one of the plurality of camera modules 205 and 212 may be a wide-angle camera, and at least one of other camera modules may be a telephoto camera. Similarly, at least one (e.g., 205) of the plurality of camera modules 205 and 212 may be a front camera, and at least one of other cameras (e.g., 212) may be a rear camera. In addition, the plurality of camera modules 205 and 212 may include at least one of a wide-angle camera, a telephoto camera, or an infrared (IR) camera (e.g., a time-of-flight (TOF) camera, or a structured light camera). According to an embodiment, the IR camera may be operated as at least a part of a sensor module. For example, the TOF camera may be operated as at least a part of a sensor module (not illustrated) for detecting a distance to a subject. According to an embodiment, some of the plurality of camera modules 205 and 212 (e.g., the front camera module 205) may be implemented as an under display camera (UDC).

According to an embodiment, the key input device 217 may be disposed on the side surface 210C of the housing 210. In another embodiment, the electronic device 101 may not include some or all of the above-mentioned key input devices 217, and a key input device 217, which is not included in the above-mentioned key input devices, may be implemented in another type, such as a soft key, on the display 201. In some embodiments, a key input device may include a sensor module (not illustrated) disposed on the rear surface 210B of the housing 210.

According to an embodiment, the light-emitting element (not illustrated) may be disposed on, for example, the front surface 210A of the housing 210. The light-emitting element (not illustrated) may provide, for example, information about the state of the electronic device 101 in an optical form. In another embodiment, the light-emitting element (not illustrated) may provide a light source that is interlocked with, for example, the operation of the front camera module 205. The light-emitting element (not illustrated) may include, for example, an LED, an IR LED, and/or a xenon lamp.

According to an embodiment, the connector hole 208 may include, for example, a first connector hole 208 capable of accommodating a connector (e.g., a USB connector) for transmitting/receiving power and/or data to/from an external electronic device, and may further include a second connector hole (not illustrated) capable of accommodating a connector (e.g., an earphone jack) (not illustrated) for transmitting/receiving an audio signal to/from an external electronic device. The connector hole 208 is not limited to the above-described structure, and various design changes such as providing only some of the connector holes and adding new connector holes may be made depending on the structure of the electronic device 101.

According to an embodiment, the tray hole 209 may be, for example, a configuration for accommodating a storage medium mounting tray 219. Here, the storage medium mountable in the tray hole 209 may include at least one of a subscriber identification module (SIM) card and a secure digital (SD) card. The tray hole 209 is illustrated as being provided on the lower end surface of the housing 210 in FIGS. 2 and 3, but may be provided on the side surface or the upper end surface of the housing 210, and this arrangement may vary depending on the use, function and various designs of the electronic device 101.

According to an embodiment, a camera module 205 and/or a sensor module (not illustrated) may be disposed in the inner space of the electronic device 101 to come into contact with the external environment through a predetermined area of the display 301 and the front plate 202. For example, the predetermined area may be an area in which no pixels are not disposed in the display 201. As another example, the predetermined area may be an area in which pixels are disposed in the display 201. When viewed from above the display 201, at least a portion of the predetermined area may overlap the camera module 205 and/or the sensor module. As another embodiment, some sensor modules may be arranged in the inner space of the electronic device to implement the functions thereof without being visually exposed through the front plate 202.

Although the electronic device 101 illustrated in FIGS. 2 and 3 has a bar-type or plate-type exterior, the disclosure is not limited thereto. For example, the illustrated electronic device may be a part of a rollable electronic device or a foldable electronic device. The "rollable electronic device" may refer to an electronic device that has a deformable display so that at least a portion of the display is capable of being wound or rolled or capable of being accommodated into the housing 210. According to a user's need, the rollable electronic device may be used in the state in which the screen display area is expanded by unfolding the display or exposing a larger area of the display to the outside. A "foldable electronic device" may refer to an electronic device in which two different areas of the display are foldable to face each other or to be oriented in directions opposite to each other. In general, in the foldable electronic device in a carried state, the display is folded in the state in which two different areas face each other or in opposite directions, and in actual use, the user may unfold the display such that the two different areas form a substantially flat plate shape. In some embodiments, the electronic device 101 according to various embodiments disclosed herein may be interpreted as including not only a portable electronic device such as a smartphone, but also various other electronic devices such as a notebook computer or a home appliance.

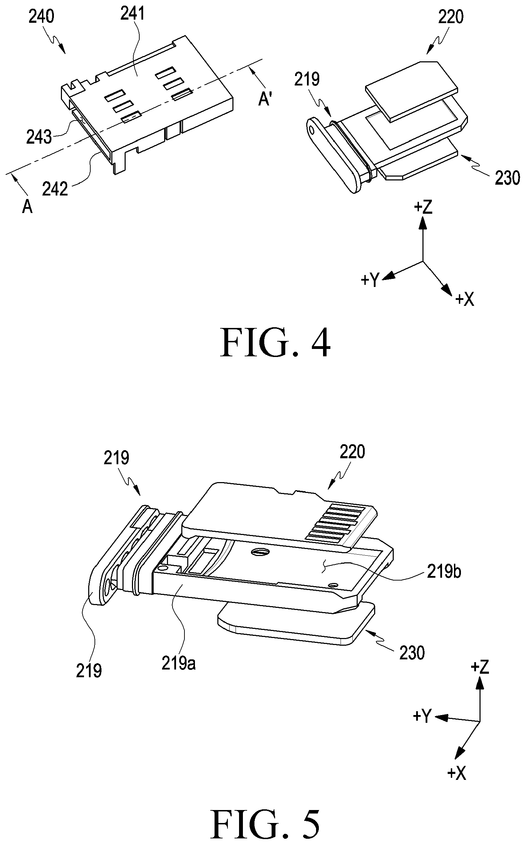

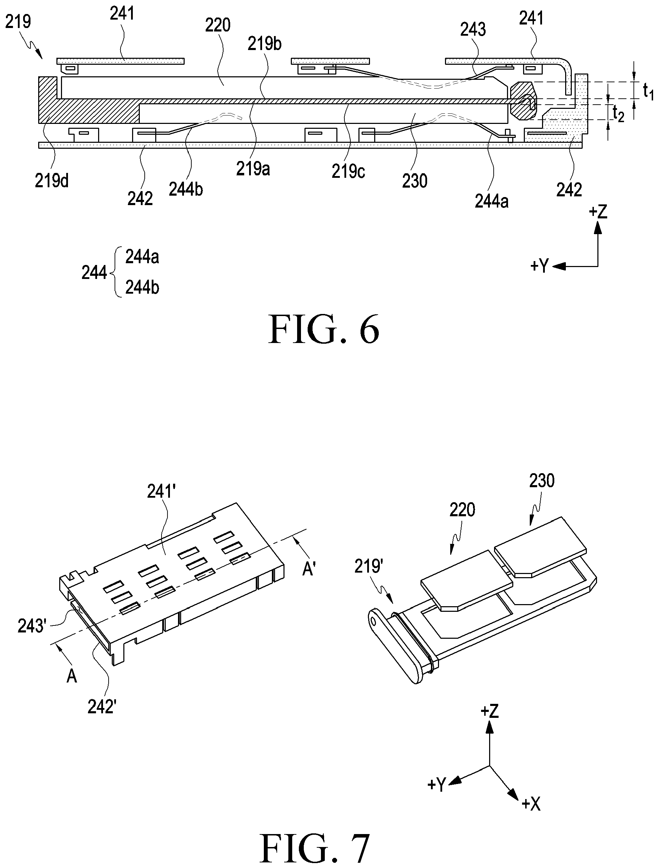

FIG. 4 is a perspective view illustrating a socket and a tray according to a comparative embodiment. FIG. 5 is a perspective view illustrating the tray according to the comparative embodiment. FIG. 6 is a cross-sectional view illustrating a state in which the tray is mounted in the inner space of the socket according to the comparative embodiment. FIG. 6 may illustrate a cross section cut in A-A' direction in FIG. 4 in the state in which the tray on which a storage medium is seated is accommodated in the socket.

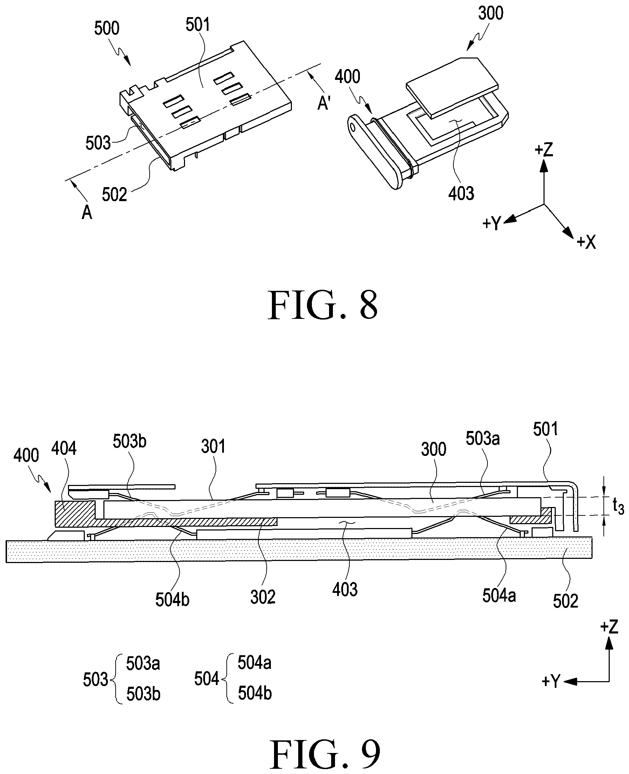

FIGS. 4 to 6 may illustrate a tray 219 that is capable of being inserted into and/or taken out through a tray hole (e.g., the tray hole 209 in FIG. 2) of a housing (e.g., the housing 210 in FIG. 2) according to a comparative embodiment for a tray 400 according to various embodiments of the disclosure to be described later with reference to FIG. 9.

Referring to FIG. 4, the tray 219 may be used for user authentication and/or expansion of storage capacity or function of an electronic device (e.g., the electronic device 101 in FIG. 1) by being inserted into a through hole (e.g., the through hole 209 in FIG. 2) in a housing (e.g., the housing 210 in FIG. 2) in the state in which two storage media 220 and 230 are seated thereon. The storage media 220 and 230 may include, for example, a subscriber identification module (SIM) card and/or an SD card.

Referring to FIGS. 5 and 6 together, the tray 219 may include a base plate 219a and a cover member 219d provided at one end of the base plate 219a. When the tray 219 is inserted into the through hole (e.g., the through hole 209 of FIG. 2) of the housing (e.g., the housing 210 of FIG. 2), the cover member 219d may define a portion of the exterior of the housing, and according to an embodiment, the cover member 219d may block the entrance of the through hole 209 to prevent other foreign substances from entering the through hole 209. The base plate 219a may provide a surface or space for mounting a storage medium (e.g., the SD card 220 and/or the SIM card 230). For example, the tray 219 may include two seating portions 219b and 219c provided on the base plate 219a. The seating portions 219b and 219c may have shapes corresponding, respectively, to the shapes of storage media to be seated thereon. For example, when the storage media 220 and 230 are seated on the seating portions 219b and 219c, the outer surfaces of the storage media 220 and 230 may be supported from the inner wall of the base plate 219a defining the seating portions 219b and 219c.

Referring to FIGS. 4 and 6 together, a socket 240 may be provided in the through hole (e.g., through hole 209 in FIG. 2) of the housing (e.g., housing 210 of FIG. 2). The socket 240 may include a first plate 241 and a second plate 242 which are plates provided to surround at least a portion of a space 240a (hereinafter, referred to as a "slot 240a") in which the tray 219 is detachably provided. In the state in which the storage media 220 and 230 are seated, when the tray 219 is inserted into the tray hole 209, at least a portion of the storage media 220 and 230 may be accommodated in the slot 240a of the socket 240. The socket 240 may include a plurality of contacts 243 and 244 to come into contact with a plurality of connection pins (or pads) which are provided in each of the two different storage media 220 and 230. For example, the plurality of contacts 243 and 244 may be terminals such as pins, pogo pins, and C-clips. In FIG. 6, a plurality of contacts 243 and 244 may connect storage media 220 and 230 of the electronic device to electronic components (e.g., the processor 120 or the communication module 190 in FIG. 1) provided in the electronic device (e.g., the electronic device 101 in FIG. 6) in a widthwise direction.

The tray 219 according to the comparative embodiment illustrated in FIGS. 4 to 6 may illustrate an overlap-type dual card tray in which two storage media 220 and 230 are seated, respectively, on one surface and the other surface of the plate of the tray 219 and a socket 240 having a shape corresponding to that of the overlapping dual card tray. When the storage media 220 and 230 are seated on the tray 219 and then the tray is inserted into the socket 240, one 243 of the plurality of contacts 243 and 244 provided in the socket 240 may come into contact with the storage medium 220 seated on the plate 219a, and another one 244 may come into contact with the storage medium 230 seated under the plate 219a. According to the comparative embodiment of FIGS. 4 to 6, since the two storage media 220 and 230 are seated, respectively, on and under the tray 219 in the state of being functionally and physically separated from each other, the size of the storage media may have a large size in the height direction (or the thickness direction) (e.g., the +Z direction) of the electronic device. For example, the two storage media 220 and 230 may have thicknesses of tl and t2, respectively, and the total height of the tray 219 on which the storage media 220 and 230 are seated may correspond to the sum of the thicknesses of the two storage media 220 and 230 and the thickness of the base plate 219a. The tray 219 on which the two storage media 220 and 230 are seated may be a constraint on the trend of improving portability according to the miniaturization of electronic devices.

FIG. 7 is a perspective view illustrating a socket and a tray according to another comparative embodiment.

The tray 219' according to the embodiment illustrated in FIG. 7 may illustrate a series type dual card tray in which two storage media 220 and 230 are seated on one surface of the plate of the tray 219' along the longitudinal direction (e.g., the +Y direction) of the tray 219' and a socket 240' having a shape corresponding to the series type dual card tray. When the storage media 220 and 230 are seated on the tray 219' and then the tray is inserted into the socket 240', one of the plurality of contacts (not illustrated) provided in the socket 240' may come into contact with the storage medium 220 seated on the front end of the tray 219' (e.g., the outer portion of the tray hole 209 into which the tray is inserted), and another one may come into contact with the storage medium 230 on the rear end of the tray 219' (e.g., the inner portion of the tray hole 209 in to which the tray is inserted). Even in the case of the comparative embodiment of FIG. 7, since the two storage media 220 and 230 are seated, respectively, on the front end and the rear end of the tray 219' in the state of being functionally and physically separated from each other, the tray 219' may have a large size in the longitudinal direction (e.g., the +Y direction). This embodiment may also be a constraint on the trend of improving portability due to miniaturization of electronic devices. In view of the embodiments of FIGS. 4 to 7 in combination, it can be seen that the sizes of a tray and a socket may vary depending on the types of storage media seated on the tray, the number of storage media, and the arrangement method of storage media when there are a plurality of storage media, and are also closely related to the size of the electronic device.

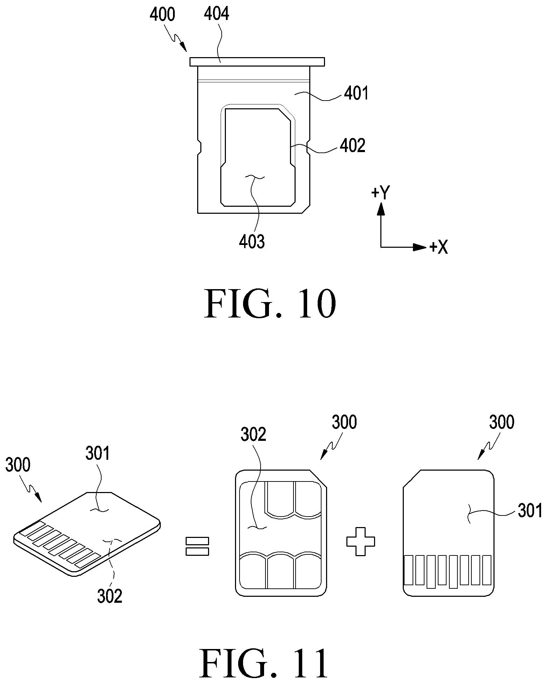

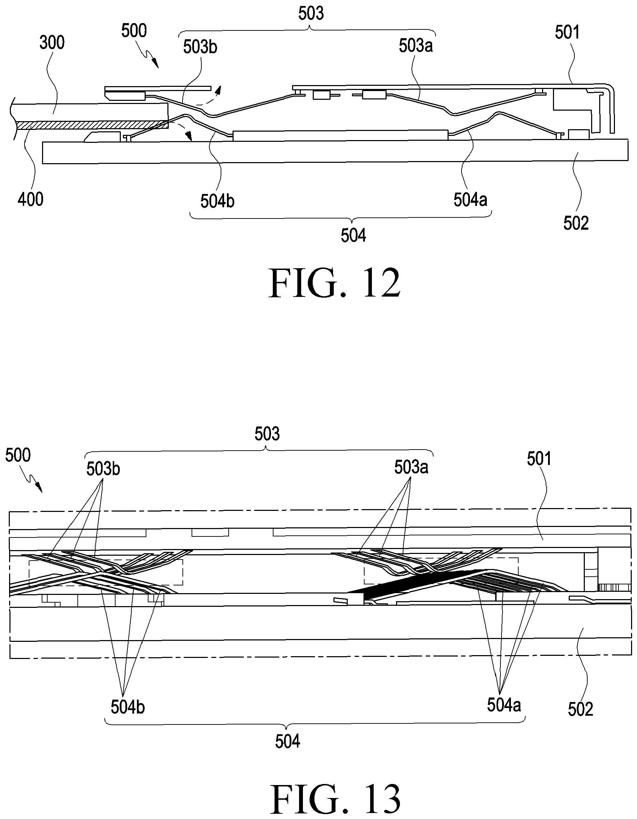

FIG. 8 is a view illustrating a socket and a tray according to various embodiments. FIG. 9 is a cross-sectional view illustrating a state in which the tray is mounted in the inner space of the socket according to various embodiments. FIG. 10 is a view illustrating the tray according to various embodiments when viewed from above. FIG. 11 is a view illustrating a storage medium according to various embodiments. FIG. 12 is a view illustrating a behavior of conductive contacts when a tray enters a socket according to various embodiments of the disclosure.

FIG. 9 may illustrate a cross section of a socket cut in A-A' direction in the state in which the tray on which a storage medium 300 is seated is accommodated in the socket 500 illustrated in FIG. 8.

Referring to FIGS. 8 to 11 together, an electronic device (e.g., the electronic device 101 in FIG. 1) according to various embodiments of the disclosure may include a tray 400 configured to be detachably provided (inserted into and/or taken out) through a tray hole (e.g., the tray hole 209 in FIG. 2) of the housing (e.g., the housing 210 in FIG. 2). According to an embodiment, the tray 400 may be utilized for user authentication and/or storage capacity or function expansion of the electronic device 101 while having a compact size in the height direction (e.g., the +Z direction) and/or the longitudinal direction (the +Y direction) of the electronic device 101 by being inserted into the tray hole 209 in the state in which one storage medium 300 is seated thereon. However, the storage medium 300 according to various embodiments of the disclosure is a storage medium provided with terminals on both surfaces thereof, and may include a subscriber identification module card (e.g., a SIM card) and/or a memory card (e.g., a SD card) on each of one surface and the other surface thereof. For example, the storage medium 300 may include a first terminal surface 301 and a second terminal surface 302 facing away from the first terminal surface 301, wherein each of the first terminal surface 301 and the second terminal surface 302 may be provided with metal terminals (or pins) of a subscriber identification module card (hereinafter, simply referred to as a "SIM card") and/or a secure digital card (hereinafter, simply referred to as an "SD card"). FIG. 11 illustrates that the SD card is provided on the first terminal surface 301 of the storage medium 300 and the SIM card is provided on the second terminal surface 302 of the storage medium 300. However, the disclosure is not limited thereto, and is applicable to an embodiment in which the SIM card is provided on the first terminal surface 301 of the storage medium 300 and the SD card is provided on the second terminal surface 302 of the storage medium 300 may also be applied, unlike that illustrated in the drawing. In addition, the disclosure is also applicable to an embodiment in which SIM cards are provided on both the first terminal surface 301 and the second terminal surface 302 of the storage medium 300, or an embodiment in which SD cards are provided both the first terminal surface 301 and the second terminal surface 302. Hereinafter, for convenience of description, an embodiment in which the SD card is provided on the first terminal surface 301 of the storage medium 300 and the SIM card is provided on the second terminal surface 302 will be mainly described, but it should be noted that the scope of the disclosure is not limited thereto.

According to various embodiments, the tray 400 may include a base plate 401 and a cover member 404 provided at one end of the base plate 401. The base plate 401 may provide a surface or space for mounting a storage medium (e.g., a SIM card and/or an SD card). For example, a seating portion 402 for seating the storage medium 300 may be provided on one surface of the base plate 401. In various embodiments of the disclosure, since only one storage medium 300 is seated on the tray 400, the seating portion 402 may also be provided on only one surface of the base plate 401 to correspond to the storage medium. The seating portion 402 may have a shape corresponding to the shape of storage medium to be seated thereon. For example, the seating portion 402 may have a shape corresponding to the outer shape of the SIM card or a shape corresponding to the outer shape of the SD card. In addition, through the through hole 403 provided in the base plate 401, not only one surface (e.g., the first terminal surface 301) of the storage medium 300, but also the other surface (e.g., the second terminal surface 302) of the storage medium 300 may be exposed to the outside. Here, the "outside" may refer to the inner space of the socket 500 in the state in which the tray 400 is accommodated in the through hole 403. For example, when the first terminal surface 301 of the storage medium 300 is seated on the seating portion 402 provided on one surface of the base plate 401, the second terminal surface 302 of the storage medium 300 may be exposed to the outside as it is in a direction opposite to the first terminal surface 301, and the first terminal surface 301 of the storage medium 300 may be exposed to the outside through the through hole 403. When the storage medium 300 is seated on the seating portion 402, the inner surface defining the seating portion 402 of the base plate 401 may support the edge portions of the storage medium 300 and stably maintain the position of the storage medium 300.

According to various embodiments, the cover member 404 of the tray 400 may facilitate handling of the tray 400 by a user, and the tray 400 may close the tray hole (e.g., the tray hole 209 in FIG. 2) in the state in which the tray 400 is inserted into the housing (e.g., the housing 210 of FIG. 2). For example, the cover member 404 may close the tray hole 209 to reduce the inflow of foreign substances or the like into the housing 210, while defining a portion of the exterior of the housing 210.

Referring to FIGS. 8 to 11 together, when the tray 400 is inserted into the housing (e.g., the housing 210 in FIG. 2) in the state in which the storage medium 300 is seated on the tray 400, at least a portion of the storage medium 300 may be disposed in the inner space of the socket 500. Similarly to the socket 240 described above with reference to FIGS. 4 to 6, the socket 500 of FIG. 8 may be provided to connect the storage medium 300 to electronic components (e.g., the processor 120 or the communication module 190 in FIG. 1) provided on a circuit board (not illustrated) of the electronic device (e.g., the electronic device 101 in FIG. 1) while providing a space 500 (hereinafter, referred to as a "slot 500a") for accommodating the tray 400. The socket 500 may include a first plate 501 and a second plate 502 as plates provided to surround at least a portion of the slot 500a in which the tray 400 is detachably provided. In the state in which the storage medium 300 is seated, when the tray 400 is inserted into the tray hole (e.g., the tray hole 209 in FIG. 2), at least a portion of the storage medium 300 may be accommodated in the slot 500a of the socket 500. The socket 500 may include a plurality of contacts 503 and 504 to come into contact with a plurality of connection pins (or pads) provided on each of both surfaces (the first terminal surface 301 and the second terminal surface 302) of the storage medium 300. According to an embodiment, the socket may include a plurality of first conductive contacts 503 that face the first terminal surface 301 and come into contact with at least some of the plurality of pins provided on the storage medium 300 and a plurality of second conductive contacts 504 that face the second terminal surface 302 and come into contact with at least some of the plurality of pins of the storage medium 300 in the state of being disposed not to come into contact with the plurality of first conductive contacts 503. For example, the plurality of first conductive contacts 503 and the plurality of second conductive contacts 504 may be terminals such as pins, pogo pins, and C-clips.

Referring to FIG. 12, in the case where the tray 400 on which the storage medium 300 is seated is accommodated and mounted in the slot 500a of the socket 500, when the tray 400 enters, the plurality of first conductive contacts 503 may be pressed upward according to the insertion of the storage medium 300, and the plurality of second conductive contacts 504 may be pressed downward according to the insertion of the storage medium 300. According to various embodiments, the socket 500 may include a plurality of (1-1)^{th} conductive contacts 503a and a plurality of (1-2)^{th} conductive contacts 503b, which are disposed, respectively, at a first portion and a second position, which are separated from each other in the longitudinal direction (e.g., the +Y direction) of the socket, and a plurality of (2-1)^{th} conductive contacts 504a and a plurality of (2-2)^{th} conductive contacts 504b, which are disposed at the first position and the second position, respectively. Here, the "first position" may be an inner portion of the slot 500a, and the "second position" may be an outer portion of the slot 500a (the portion which the tray 400 is to enter at the time of being mounted). Accordingly, at the time of first entry of the tray 400, the plurality of (1-2)^{th} conductive contacts 503b and the plurality of (2-2)^{th} conductive contacts 504b may be pressed first, and then the plurality of (1-1)^{th} conductive contacts 503a and the plurality of (2-1)^{th} conductive contacts 504a may be pressed. When the tray 400 is fully mounted, the plurality of first conductive contacts 503 may come into contact with the first terminal surface 301 of the storage medium 300, and the plurality of second conductive contacts 504 may come into contact with the second terminal surface 302 of the storage medium 300 through the through hole 403 of the tray 400.

According to various embodiments of the disclosure, a double-sided contact structure may be provided from the viewpoint of the storage medium 300, but a single-sided contact structure may be provided from the viewpoint of each of cards (e.g., a SIM card and an SD card). According to this, for example, when a SIM card and an SD card are provided, respectively, on one surface and the other surface of the storage medium 300, user authentication and expansion of storage capacity or function of the electronic device 101 may be implemented by using only one storage medium 300. For example, only one storage medium 300 may be seated on the tray 400 illustrated in FIGS. 8 to 12. The storage medium 300 may have a thickness of t3, and the total height of the tray 400 on which the storage medium 300 is seated may be the sum of the thickness of one storage medium 300 and the thickness of the base plate 401. The tray 400 on which one storage medium 300 is seated as described above may be configured to have a smaller height than the tray 219 on which two storage media 220 and 230 according to the comparative embodiment described above in FIGS. 4 to 6 are seated, thereby following the trend of miniaturization and improvement of portability of electronic devices.

In the embodiment illustrated in FIGS. 8 to 12, for example, when a SIM card is provided on the first terminal surface 301 of the storage medium 300 and an SD card is provided on the second terminal surface 302 of the storage medium 300, the plurality of (1-1)^{th} conductive contacts 503a and the plurality of (1-2)^{th} conductive contacts 503b may come into contact with metallic terminals (e.g., pins) of the SIM card on the first terminal surface 301, and the plurality of (2-1)^{th} conductive contacts 504a may come into contact with metallic terminals (e.g., pins) of the SD card of the second terminal surface 302. Meanwhile, unlike the plurality of (1-1)^{th} conductive contacts 503a, the plurality of (1-2)^{th} conductive contacts 503b, and the plurality of (2-1)^{th} conductive contacts 504a, which come into contact with metallic terminals (e.g., pins), the plurality of (2-2)^{th} conductive contacts 504b may not come into contact with metallic terminals (e.g., pins). The sizes of the tray and the socket may vary depending on the types of storage media seated on the tray, the number of storage media, and an arrangement method when there are a plurality of storage media. In addition, the sizes of a tray and a socket are closely related to the size of an electronic device, and thus may be an important factor in designing the electronic device. The type, number, and arrangement method of storage media may be predetermined in the design stage of the electronic device. When a SIM card is provided on one surface of a storage medium and an SD card is provided on the other surface, factors such as the number and positions of contacts of the socket may be determined in consideration of the arrangement of the storage media. For example, when a SIM card is provided on one surface and an SD card is provided on the other surface, in some comparative embodiments (e.g., the embodiment of FIG. 6), two different positions (the first position and the second position) on the side that is in contact with the SIM card may be provided with contacts, and one position (the first position) that is in contact with the SD card may be provided with a contact. Unlike this, according to various embodiments of the disclosure, even on the side that is in contact with the SD card, each of two positions (the first position and the second position) may be provided with a contact. At this time, a contact positioned in a portion that does not come into contact with the metallic terminals (e.g., pins) of the SD card may be a balance tuning contact (hereinafter, referred to as a "balance contact") for ensuring the stability of the contact by providing a uniform contact pressure (e.g., the force in the arrow direction in FIG. 8).

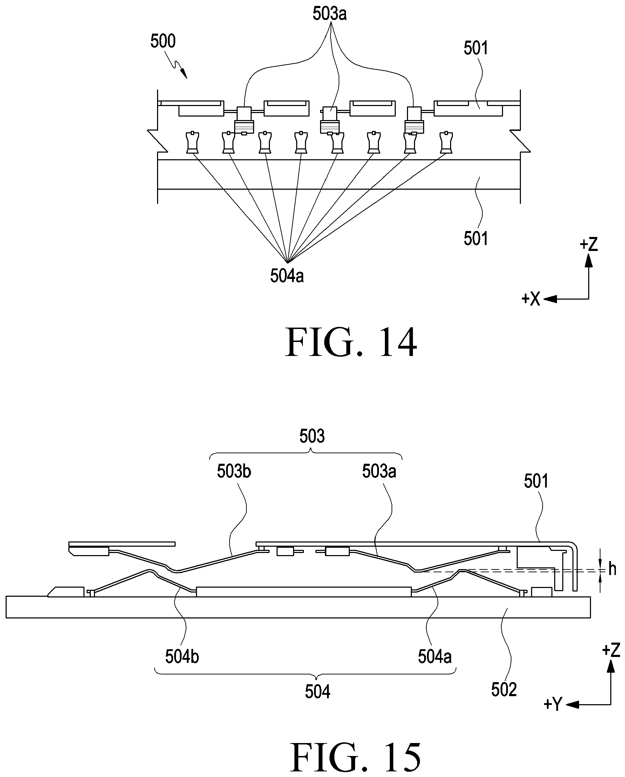

FIG. 13 is a view illustrating a socket according to various embodiments. FIG. 14 is a view illustrating a cross section of the socket according to various embodiments, cut in a width direction. FIG. 15 is a view illustrating a cross section of the socket according to various embodiments, cut in a longitudinal direction.

According to various embodiments, the socket 500 may include a plurality of (1-1)^{th} conductive contacts 503a and a plurality of (1-2)^{th} conductive contacts 503b, which are disposed, respectively, at a first portion and a second position, which are separated from each other in the longitudinal direction (e.g., the +Y direction) of the socket, and a plurality of (2-1)^{th} conductive contacts 504a and a plurality of (2-2)^{th} conductive contacts 504b, which are disposed at the first position and the second position, respectively. Here, a plurality of (1-1)^{th} conductive contacts 503a and a plurality of (2-1)^{th} conductive contacts 504a may be provided at the first position, and a plurality of (1-2)^{th} conductive contacts 503b and a plurality of (2-2)^{th} conductive contacts 504b may be provided at the second position, as illustrated in FIG. 13. FIG. 13 may illustrate, for example, cross sections of the (1-1)^{th} conductive contacts 503a and the (2-1)^{th} conductive contacts 504a at the first position in the width direction (e.g., in the +X direction of FIG. 14). In the embodiment illustrated in FIG. 13 as well, there may be provided a plurality of (1-1)^{th} conductive contacts 503a and a plurality of (2-1)^{th} conductive contacts 504a. Here, the number of contacts is not limited to a specific embodiment and may vary from embodiment to embodiment.

According to various embodiments, the first conductive contacts 503 and the second conductive contacts 504 may have an overlapping structure in the height direction (e.g., the +Z direction) of the socket 500 as illustrated in FIGS. 14 and 15 in order to secure a stable amount of pressing. For example, the plurality of (1-1)^{th} conductive contacts 503a and the plurality of (2-1)^{th} conductive contacts 504a disposed at the first position may at least partially overlap in the height direction by the thickness h thereof (e.g., the +Z direction) of the socket 500, and the plurality of (1-2)^{th} conductive contacts 503b and the plurality of (2-2)^{th} conductive contacts 504b disposed at the second position may at least partially overlap by the thickness h thereof in the height direction of the socket 500 (e.g., the +Z direction).

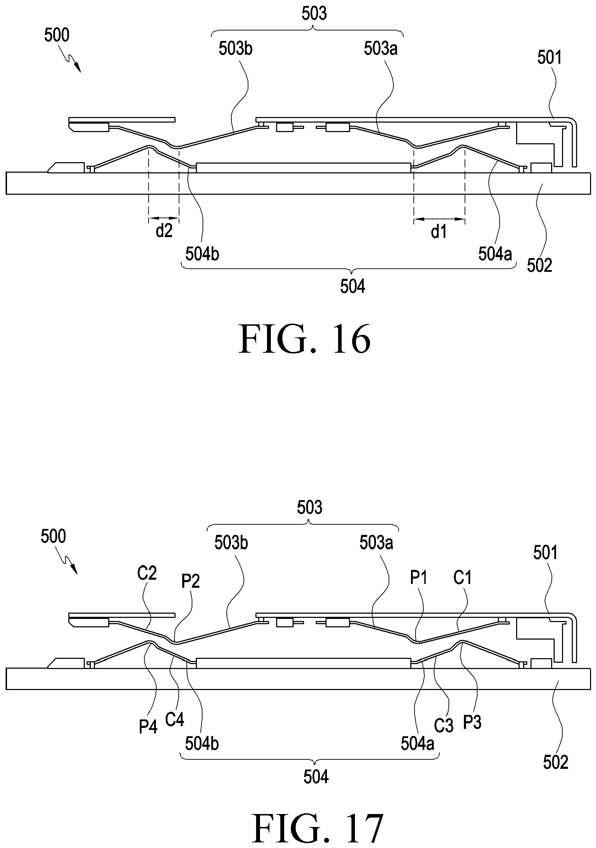

FIG. 16 is a view illustrating an arrangement relationship between first conductive contacts and second conductive contacts in a cross section of a socket according to various embodiments, cut in a longitudinal direction. FIG. 17 is a view illustrating an arrangement relationship between first conductive contacts and second conductive contacts in a cross section of a socket according to various embodiments, cut in a longitudinal direction.

According to FIGS. 16 and 17, the tips P1 of a plurality of (1-1)^{th} conductive contacts 503a and the tips P3 of a plurality of (2-1)^{th} conductive contacts 504a disposed at a first position may be disposed not to interfere with each other in the height direction of the socket 500 (e.g., the +Z direction), and the tips P2 of a plurality of (1-2)^{th} conductive contacts 503b and the tips P4 of a plurality of (2-2)^{th} conductive contacts 504b disposed at a second position may be disposed not to interfere with each other in the height direction of the socket 500 (e.g., the +Z direction). In this case, the tips P1 of the (1-1)^{th} conductive contacts 503a and the tips P3 of the plurality of (2-1)^{th} conductive contacts 504a may be spaced apart from each other by a first distance d1 in the longitudinal direction of the socket 500 (e.g., the +Y direction), and the tips P2 of the (1-2)^{th} conductive contacts 503b and the tips P4 of the plurality of (2-2)^{th} conductive contacts 504b may be spaced apart from each other by a second distance d2 in the longitudinal direction of the socket 500 (e.g., the +Y direction). Here, the first distance d1 and the second distance d2 may be different from or the same as each other.

In addition, the tips P1 of the plurality of (1-1)^{th} conductive contacts 503a are disposed at positions corresponding to the inclined portions C3 of the plurality of (2-1)^{th} conductive contacts 504a, and the tips P3 of the plurality of (2-1)^{th} conductive contacts 504a may be disposed at positions corresponding to the inclined portions C1 of the plurality of (1-1)^{th} conductive contacts 503a. Furthermore, the tips P2 of the plurality of (1-2)^{th} conductive contacts 503b are disposed at positions corresponding to the inclined portions C4 of the plurality of (2-2)^{th} conductive contacts 504b, and the tips P4 of the plurality of second conductive contact 504b may be disposed at positions corresponding to the inclined portion C2 of the plurality of (1-2)^{th} conductive contacts 503b. In order to increase the amount of pressing of the plurality of contacts, the contact arrangement structure illustrated in FIGS. 16 and 17 may be provided.

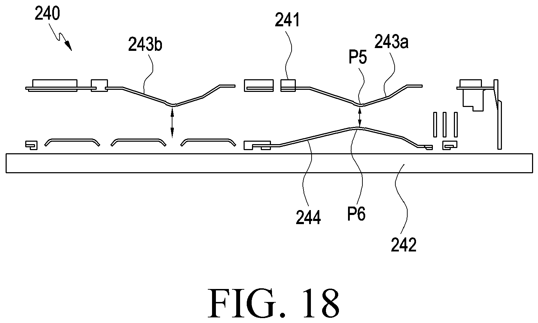

FIG. 18 is a view illustrating an arrangement relationship between first conductive contacts and second conductive contacts in a cross section of a socket according a comparative embodiment, cut in a longitudinal direction.

The socket 240 according to the comparative embodiment may include a (1-1)^{th} conductive contact 243a and a second conductive contact 244 disposed at a first position. In addition, the socket 240 may include a (1-2)^{th} conductive contact 243b at a second position. Referring to FIG. 18, the (1-1)^{th} conductive contact 243a and the second conductive contact 244 may not interfere with each other even if the respective tips P5 and P6 thereof are configured to overlap each other in the state of facing each other. However, in such a structure, the size (e.g., thickness) of the tray to be inserted into the slot of the socket 240 can be very large, which may be in opposition to the trend of miniaturization of electronic devices. In contrast to this, according to various embodiments of the disclosure, there is no interference while providing a sufficient amount of pressing when the tray is mounted since the tips at positions corresponding to each other are staggered to each other in the state in which the plurality of conductive contacts overlap each other.

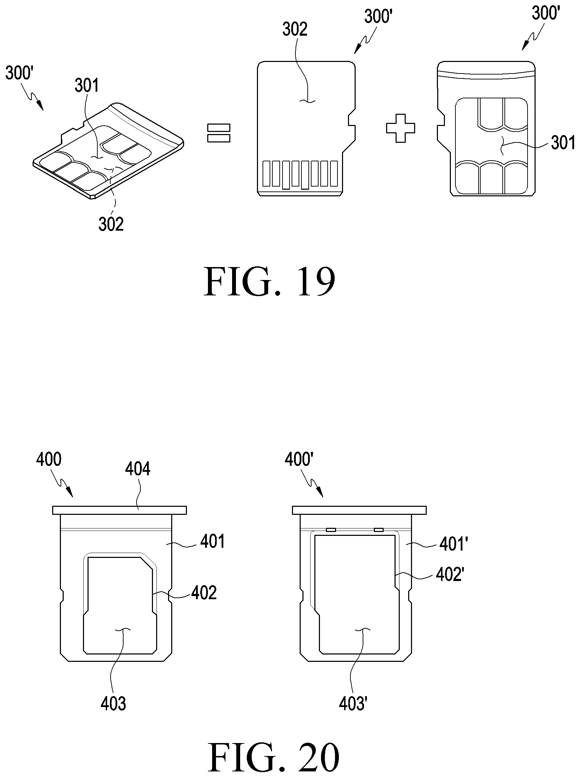

FIG. 19 is a view illustrating a storage medium according to various embodiments. FIG. 20 is a view illustrating a tray according to various embodiments.

According to various embodiments of the disclosure, a storage medium 300' that is capable of being mounted on the socket 500 may include a SIM card and/or an SD card provided on each of both surfaces thereof, and may be variously applied from embodiment to embodiment. FIG. 19 illustrates that a SIM card is provided on a first terminal surface 301 of the storage medium 300' and an SD card is provided on a second terminal surface 302 of the storage medium 300'.

According to various embodiments, the size and external shape of the storage medium 300' may also be variously applied from embodiment to embodiment. For example, the embodiment of FIG. 11 illustrates that the storage medium 300 has an external shape of an SD card, but the embodiment of FIG. 19 illustrates that the storage medium 300' has an external shape of a SIM card. As mentioned above, the shape of the seating portion 402 of the tray 400 may have an external shape corresponding to the external shape of the storage medium 300 or 300' mounted thereon. For example, when the storage medium 300 having the external shape of the SD card of FIG. 11 is mounted, the seating portion 402 may have a shape as illustrated in the left drawing of FIG. 20. In addition, when the storage medium 300' having the shape of the SIM card of FIG. 19 is mounted, the seating portion 402 may have a shape as illustrated in the right drawing of FIG. 20.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, it is possible to provide an electronic device including: a housing constituting at least a portion of an exterior of the electronic device; a socket disposed inside the housing; a tray detachably provided in the socket and a storage medium including a first terminal surface with a terminal and a second terminal surface with a terminal, the first and second terminal surfaces facing away from one another and the storage medium being seatable on the tray, wherein the socket includes a plurality of first conductive contacts that face the first terminal surface and come into contact with at least some of a plurality of pins provided on the storage medium, and a plurality of second conductive contacts that face the second terminal surface and come into contact with at least some of the plurality of pins of the storage medium in a state of being disposed not to come into contact with the plurality of first conductive contacts.

According to various embodiments, the tray may be provided on one surface thereof with a seating portion on which the storage medium is seated.

According to various embodiments, in the storage medium, each of the first terminal surface and the second terminal surface may be provided with one of a subscriber identification module (SIM) card or a secure digital (SD) card.

According to various embodiments, in the storage medium, the SIM card may be provided on the first terminal surface and the SD card may be provided on the second terminal surface, or the SD card may be provided on the first terminal surface and the SIM card may be provided on the second terminal surface.

According to various embodiments, the seating portion of the tray corresponds in shape to an outer shape of the SIM card or to an outer shape of the SD card.

According to various embodiments, the tray may be provided with a through hole, and the seating portion may surround at least a portion of the through hole.

According to various embodiments, when the tray on which the storage medium is seated is accommodated and mounted in the inner space of the socket, the plurality of first conductive contacts may come into contact with the first terminal surface of the storage medium, and the plurality of second conductive contacts may come into contact with the second terminal surface of the storage medium through the through hole.

According to various embodiments, the socket may include a first plate on which the plurality of first conductive contacts are provided and a second plate on which the plurality of second conductive contacts are provided, as plates that are provided to surround at least a portion of the space in which the tray is detachably provided.

According to various embodiments, the socket may be provided on a board included inside the housing.

According to various embodiments, the second plate of the socket may constitute a portion of the board.

According to various embodiments, when the storage medium includes the SIM card on the first terminal surface of the storage medium and the SD card on the second terminal surface, the socket may include a plurality of (1-1)^{th} conductive contacts and a plurality of (1-2)^{th} conductive contacts which are disposed, respectively, at a first position and a second position, which are separated from each other in a longitudinal direction of the socket, and may include a plurality of (2-1)^{th} conductive contacts and a plurality of (2-2)^{th} conductive contacts which are disposed, respectively, at the first position and the second position.

According to various embodiments, the plurality of (2-2)^{th} conductive contacts may be balance contacts that do not come into contact with the plurality of pins of the storage medium.

According to various embodiments, the plurality of (1-1)^{th} conductive contacts and the plurality of (2-1)^{th} conductive contacts disposed at the first position may at least partially overlap each other in the height direction of the socket, and the plurality of (1-2)^{th} conductive contacts and the plurality of (2-2)^{th} conductive contacts disposed at the second position may at least partially overlap each other in the height direction of the socket.

According to various embodiments, tips of the plurality of (1-1)^{th} conductive contacts and tips of the plurality of (2-1)^{th} conductive contacts, which are disposed at the first position, may be provided so as not to interfere in a height direction of the socket, and tips of the plurality of (1-2)^{th} conductive contacts and tips of the plurality of (2-2)^{th} conductive contacts, which are disposed at the second position, may be provided so as not to interfere in the height direction of the socket.

According to various embodiments, tips of the plurality of (1-1)^{th} conductive contacts may be disposed at positions corresponding to inclined portions of the plurality of (2-1)^{th} conductive contacts, and tips of the plurality of (2-1)^{th} conductive contacts may be disposed at positions corresponding to inclined portions of the plurality of (1-1)^{th} conductive contacts, and tips of the plurality of (1-2)^{th} conductive contacts may be disposed at positions corresponding to inclined portions of the plurality of (2-2)^{th} conductive contacts, and tips of the plurality of (2-2)^{th} conductive contacts may be disposed at positions corresponding to inclined portions of the plurality of (1-2)^{th} conductive contacts.

According to various embodiments, it is possible to provide an electronic device including: a housing constituting at least a portion of an exterior of the electronic device; a socket disposed inside the housing; a tray including on one surface thereof a seating portion on which the storage medium is seatable and detachably provided in the socket; and a storage medium comprising a first terminal surface with a terminal and a second terminal surface with a terminal, the first and second terminal surfaces facing away from one another and the storage medium being seatable on the seating portion of the tray, wherein the socket includes a plurality of first conductive contacts that face the first terminal surface and come into contact with at least some of a plurality of pins provided on the storage medium, a plurality of second conductive contacts that face the second terminal surface and come into contact with at least some of the plurality of pins of the storage medium in a state of being disposed not to come into contact with the plurality of first conductive contacts, and a plurality of third conductive contacts that do not come into contact with the plurality of pins of the storage medium.

According to various embodiments, in the storage medium, each of the first terminal surface and the second terminal surface may be provided with one of a subscriber identification module (SIM) card and a secure digital (SD) card.

According to various embodiments, the seating portion may have a shape corresponding to an outer shape of the SIM card or a shape corresponding to an outer shape of the SD card.

According to various embodiments, it is possible to provide an electronic device including: a housing constituting at least a portion of an exterior of the electronic device; a socket disposed inside the housing; and a tray including on one surface thereof a seating portion on which the storage medium is seatable and detachably provided in the socket, wherein the socket includes a plurality of first conductive contacts that, when the storage medium is seated, face the first terminal surface of the storage medium and come into contact with at least some of a plurality of pins provided on the storage medium, a plurality of second conductive contacts that face the second terminal surface of the storage medium and come into contact with at least some of the plurality of pins of the storage medium in a state of being disposed not to come into contact with the plurality of first conductive contacts, and a plurality of third conductive contacts that do not come into contact with the plurality of pins of the storage medium.

According to various embodiments, the tray may be provided with a through hole, and the seating portion may surround at least a portion of the through hole, and when the tray on which the storage medium is seated is accommodated and mounted in the inner space of the socket, the plurality of first conductive contacts may come into contact with the first terminal surface of the storage medium, and the plurality of second conductive contacts may come into contact with the second terminal surface of the storage medium through the through hole.

According to various embodiments, it is possible to provide an electronic device including: a housing; a socket disposed in the housing; a tray detachably provided in the socket; and a storage medium seatable on the tray and comprising a first terminal surface with a terminal and a second terminal surface with a terminal, wherein the socket comprises: a plurality of first conductive contacts that face the first terminal surface and come into contact with at least some of a plurality of pins provided on the storage medium; and a plurality of second conductive contacts that face the second terminal surface and come into contact with at least some of the plurality of pins provided on the storage medium.

According to various embodiments, the first and second terminal surfaces face away from one another.

According to various embodiments, the storage medium comprises a subscriber identification module (SIM) card and a secure digital (SD) card, the first terminal surface is a surface of the SIM card and the second terminal surface is a surface of the SD card, and the tray comprises seating portions on opposite sides thereof on which the SIM card and the SD card are respectively seatable.

According to various embodiments, the seating portions on which the SIM card and the SD card are respectively seatable have respective shapes corresponding to the SIM card and the SD card.

In the foregoing detailed description of the disclosure, specific embodiments have been described. However, it will be evident to a person ordinarily skilled in the art that various modifications can be made without departing from the scope of the disclosure.

## Claims

1. An electronic device comprising:
a housing forming at least a portion of an exterior of the electronic device;
a socket disposed inside the housing;
a tray detachably provided in the socket; and
a storage medium comprising a first terminal surface with a terminal and a second terminal surface with a terminal, the first and second terminal surfaces facing away from one another and the storage medium being seatable on the tray,
wherein the socket comprises:
a plurality of first conductive contacts that face the first terminal surface and come into contact with at least some of a plurality of pins provided on the storage medium; and
a plurality of second conductive contacts that face the second terminal surface and come into contact with at least some of the plurality of pins of the storage medium in a state of being disposed not to come into contact with the plurality of first conductive contacts.

2. The electronic device of claim 1, wherein the tray comprises a seating portion on one surface thereof on which the storage medium is seatable.

3. The electronic device of claim 2, wherein each of the first terminal surface and the second terminal surface is provided with one of a subscriber identification module (SIM) card and a secure digital (SD) card.

4. The electronic device of claim 3, wherein the SIM card is provided on the first terminal surface and the SD card is provided on the second terminal surface, or
the SD card is provided on the first terminal surface and the SIM card is provided on the second terminal surface.

5. The electronic device of claim 4, wherein the seating portion of the tray corresponds in shape to an outer shape of the SIM card or to an outer shape of the SD card.

6. The electronic device of claim 5, wherein the tray includes a through hole and the seating portion surrounds at least a portion of the through hole.

7. The electronic device of claim 6, wherein:
the tray with the storage medium seated thereon is accommodated and mounted in inner space of the socket, and
the plurality of first conductive contacts come into contact with the first terminal surface and the plurality of second conductive contacts come into contact with the second terminal surface through the through hole.

8. The electronic device of claim 1, wherein:
the socket comprises plates provided to surround at least a portion of space in which the tray is detachably provided, and
the plates comprise:
a first plate on which the plurality of first conductive contacts is provided; and
a second plate on which the plurality of second conductive contacts is provided.

9. The electronic device of claim 8, wherein the socket is provided on a board inside the housing.

10. The electronic device of claim 9, wherein the second plate of the socket forms a portion of the board.

11. The electronic device of claim 1, wherein:
the storage medium comprises a SIM card on the first terminal surface and an SD card on the second terminal surface,
the socket comprises:
a plurality of (1-1)^{th} conductive contacts and a plurality of (1-2)^{th} conductive contacts which are disposed, respectively, at a first position and a second position, which are separated from each other in a longitudinal direction of the socket; and
a plurality of (2-1)^{th} conductive contacts and a plurality of (2-2)^{th} conductive contacts which are disposed, respectively, at the first position and the second position.

12. The electronic device of claim 11, wherein the plurality of (2-2)^{th} conductive contacts are balance contacts that do not come into contact with the plurality of pins of the storage medium.

13. The electronic device of claim 11, wherein:
the plurality of (1-1)^{th} conductive contacts and the plurality of (2-1)^{th} conductive contacts, which are disposed at the first position, are configured to at least partially overlap each other in a height direction of the socket, and
the plurality of (1-2)^{th} conductive contacts and the plurality of (2-2)^{th} conductive contacts, which are disposed at the second position, are configured to at least partially overlap each other in the height direction of the socket.

14. The electronic device of claim 11, wherein:
tips of the plurality of (1-1)^{th} conductive contacts and tips of the plurality of (2-1)^{th} conductive contacts, which are disposed at the first position, are configured not to interfere in a height direction of the socket, and
tips of the plurality of (1-2)^{th} conductive contacts and tips of the plurality of (2-2)^{th} conductive contacts, which are disposed at the second position, are configured not to interfere in the height direction of the socket, and

15. The electronic device of claim 11, wherein:
tips of the plurality of (1-1)^{th} conductive contacts are disposed at positions corresponding to inclined portions of the plurality of (2-1)^{th} conductive contacts, and tips of the plurality of (2-1)^{th} conductive contacts are disposed at positions corresponding to inclined portions of the plurality of (1-1)^{th} conductive contacts, and
tips of the plurality of (1-2)^{th} conductive contacts are disposed at positions corresponding to inclined portions of the plurality of (2-2)^{th} conductive contacts, and tips of the plurality of (2-2)^{th} conductive contacts are disposed at positions corresponding to inclined portions of the plurality of (1-2)^{th} conductive contacts.
